# EUROPÄISCHE PATENTSCHRIFT

(11) **EP 1 501 341 B1**
(45) Veröffentlichungstag und Bekanntmachung des Hinweises auf die Patenterteilung: **28.02.2007**
(21) Anmeldenummer: 04012184.0
(22) Anmeldetag: 22.05.2004
(51) Int. Cl.: H05K 5/06

(54) **Anordnung zum Führen von elektrischen Leiterbahnen**
Arrangement for carrying electrical conductors
Aménagement de positionnement de pistes conductrices

(30) Priorität: 25.07.2003 DE 10333967
(43) Veröffentlichungstag der Anmeldung: 26.01.2005
(73) Patentinhaber: ROBERT BOSCH GMBH, 70442 Stuttgart (DE)
(72) Erfinder: Breuning, Christian, 72631 Aichtal (DE)

(56) Entgegenhaltungen:
- US-B1- 6 462 436
- D. P. WALDMAN: "Hermetic Seals. June 1975." IBM TECHNICAL DISCLOSURE BULLETIN, Bd. 18, Nr. 1, 1. Juni 1975 (1975-06-01), Seite 98, XP002323517 New York, US
- PATENT ABSTRACTS OF JAPAN Bd. 017, Nr. 672 (E-1474), 10. Dezember 1993 (1993-12-10) -& JP 05 226487 A (NEC CORP), 3. September 1993 (1993-09-03)

## Beschreibung

### STAND DER TECHNIK

Die vorliegende Erfindung betrifft eine Anordnung zum Führen von elektrischen Leiterbahnen, insbesondere im MID (molded interconnected devices)-Bereich, d.h. bei räumlichen, spritzgegossenen Schaltungsträgern.

Dokument US-B1-6 462 436 offenbart eine Anordnung gemäß dem ersten Teil des Anspruchs 1.

Solche räumlichen, spritzgegossenen Schaltungsträger (MID) stellen eine neuartige Dimension von Schaltungsträgern dar, wobei MIDs Formteile mit integrierter Leiterbildstruktur sind. Sie schaffen enorme technische Rationalisierungspotentiale und sind wesentlich umweltverträglicher als herkömmliche Leiterplatten. Wesentliche Einsatzgebiete für die MID-Technologie ist beispielsweise die Automobil-Elektronik im Kraftfahrzeugbereich.

Gerade im Kraftfahrzeugbereich existieren weitreichende Einsatzfelder, wie beispielsweise im Getriebebereich, in denen sich die MIDs bzw. die darauf angeordneten Steuergeräte in einer feuchten Umgebung, beispielsweise einem Ölbad, befinden. Zur Vermeidung von Beschädigungen der MIDs bzw. der damit verbundenen Schaltungen/Steuergeräte durch Kontakt mit dem Ölbad aufgrund von beispielsweise Kurzschlüssen, Verschmutzungen, etc. ist es notwendig, den sich im Ölbad befindlichen Bereich gründlich abzudichten.

Nach einem Ansatz gemäß dem Stand der Technik werden Pins bzw. Stanzgitter in ein Kunstoffspritzgußwerkzeug eingelegt und mit Kunstoff umspritzt. Anschließend wird der Kunstoffrahmen mit eingespritztem Einlegeteil und angespritztem Stecker zur Grundplatte hin dicht befestigt. In einem nächsten Schritt wird die Schaltung auf die Grundplatte aufgebracht und kontaktiert. Anschließend wird das Steuergerät mit einem Deckel verschlossen.

Nachteilig an dem oben bekannten Ansatz ist die Tatsache, daß aufgrund der Kapillarwirkung Feuchtigkeitströpfchen über die Pins in den durch den Deckel abgedichteten Innenraum zu den zu schützenden Schaltungen etc. gelangen. Somit ist eine vollständige Abdichtung und eine Verhinderung von Beschädigungen der zu schützenden Schaltungen bzw. des zu schützenden Steuergerätes nur möglich, indem die elektrischen Verbindungen über Gegenstecker und zugehörige Dichtlippe realisiert werden. Dies stellt allerdings ein zusätzliches Bauteil und somit zusätzliche Kosten dar.

### VORTEILE DER ERFINDUNG

Die erfindungsgemäße Anordnung gemäß Anspruch 1 weist gegenüber dem Stand der Technik den Vorteil auf, daß keine zusätzliche Dichtung notwendig ist und daß Pin-Stecker und entsprechende Gegenstecker für eine Verbindung des Steuergerätes mit entsprechenden Leiterbahnen nicht weiter erforderlich sind. Somit können sowohl der Fertigungsaufwand als auch die Fertigungskosten erheblich reduziert und zusätzlich eine sicherere Abdichtung geschaffen werden.

Die vorliegende Erfindung schafft diesen Vorteil dadurch, daß die Anordnung zum Führen von elektrischen Leiterbahnen einen Träger aufweist, welcher auf seiner Oberfläche einen ersten abzudichtenden Bereich und einen daran angrenzenden zweiten Bereich zum Führen der auf dem Träger angeordneten elektrischen Leiterbahn; eine in der Oberfläche des Trägers vorgesehene Nut, welche den ersten Bereich umläuft und durch welche die elektrischen Leiterbahnen für eine elektrische Verbindung zwischen dem ersten Bereich und dem zweiten Bereich verlaufen; und eine Abdeckeinrichtung aufweist, welche in die umlaufende Nut für eine dichte Abdeckung des ersten Bereichs einsetzbar ist.

In den Unteransprüchen finden sich vorteilhafte Ausgestaltungen und Weiterbildungen der vorliegenden Erfindung.

Gemäß einer bevorzugten Weiterbildung sind die elektrischen Leiterbahnen als MID-Leiterbahnen auf der Oberfläche des Trägers gebildet. Durch diese MID-Technologie sind die Leiterbahnen in der Oberfläche des Trägers integriert und durchlaufen eben die vorgesehene Nut. Somit ist eine lückenlose Abdichtung möglich.

Gemäß einem weiteren bevorzugten Ausführungsbeispiel weist die Nut einen hutförmigen, halbkreisförmigen oder ähnlichen Querschnitt auf. Der jeweilige Querschnitt kann an das entsprechend verwendete MID-Verfahren angepaßt werden, da manche MID-Verfahren steilere Neigungswinkel der Leiterbahnen ermöglichen als andere MID-Verfahren.

Vorzugsweise ist die Abdeckeinrichtung als Deckel mit einer der Nut entsprechenden Gegenrastanformung ausgebildet. Die Gegenrastanformung besitzt vorzugsweise dieselbe Querschnittsform wie die entsprechende Nut.

Die Gegenrastanformung ist vorteilhaft als umlaufende Feder ausgebildet, welche an die entsprechende Nutform angepaßt ist.

Vorzugsweise ist die Abdeckeinrichtung mittels eines Klebstoffes, beispielsweise eines DC 866-Klebstoffes in der Nut befestigbar. Der Klebstoff sollte derart gewählt werden, daß er resistent gegen die abzudichtende Flüssigkeit ist.

Gemäß einem weiteren bevorzugten Ausführungsbeispiel ist auf dem ersten Bereich des Trägers ein Steuergerät oder eine Hybridschaltung angeordnet und mit der elektrischen Leiterbahn verbindbar.

Die Materialien des Trägers, des Klebstoffs und der Abdeckeinrichtung sind vorteilhafterweise resistent gegen Maschinenöl bei einer Verwendung der erfindungsgemäßen Anordnung im Motorgetriebebereich eines Kraftfahrzeuges. Somit kann das austretende Öl die vorliegende Anordnung nicht beschädigen und nicht in den abgedichteten Innenraum zum dort vorgesehenen Steuergerät vordringen und dieses beschädigen.

Beispielsweise ist der Träger aus Kunststoff hergestellt. Insbesondere sind die Kunststoffe PBT PA ABS PEI und PES besonders geeignet.

### ZEICHNUNGEN

Im folgenden wird anhand der Figuren und der nachfolgenden Beschreibung ein Ausführungsbeispiel der vorliegenden Erfindung näher erläutert. Von den Figuren zeigen:
- Figur 1: eine perspektivische Teilansicht eines Trägers mit einem ersten abzudichtenden Bereich und einem zweiten Bereich, welche über MID-Leiterbahnen miteinander elektrisch verbunden sind, gemäß einem Ausführungsbeispiel der vorliegenden Erfindung; und
- Figur 2: eine Querschnittsansicht der erfindungsgemäßen Anordnung gemäß dem Ausführungsbeispiel der vorliegenden Erfindung.

### BESCHREIBUNG DER AUSFÜHRUNGSBEISPIELE

In den Figuren sind gleiche oder funktionsgleiche Komponenten mit gleichen Bezugszeichen versehen.

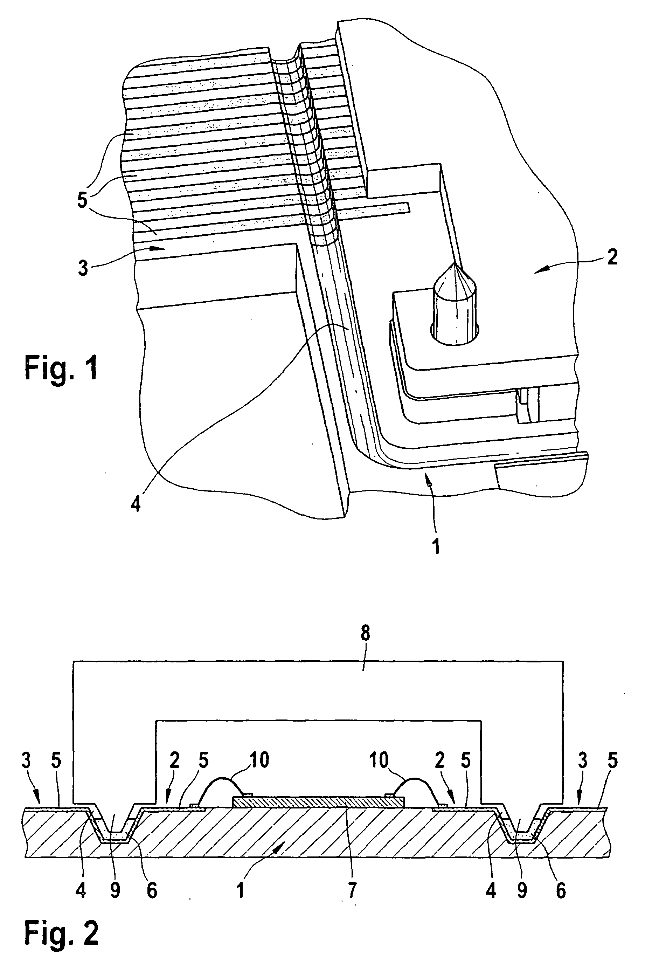

Figur 1 illustriert eine perspektivische Ansicht eines Teilausschnitts der erfindungsgemäßen Anordnung gemäß einem Ausführungsbeispiel der vorliegenden Erfindung, wobei die Anordnung einen Träger 1, welcher vorzugsweise aus einem nicht-leitfähigen Kunststoff besteht, umfaßt. Wie in Figur 1 ersichtlich ist, sind auf der Oberfläche des Trägers 1 ein erster Bereich 2 und ein zweiter Bereich 3 vorgesehen. Der erste Bereich 2 stellt den abzudichtenden Innenbereich der Anordnung dar, wobei auf diesem Bereich die zu schützenden Schaltungen bzw. Leiterplatten und Steuergeräte angeordnet sind. Beispielsweise können die in dem ersten Bereich 2 hineinlaufenden Leiterbahnen mit einer Hybrid-Schaltung elektrisch verbunden sein.

Der erste Bereich 2 ist, wie in Figur 1 dargestellt ist, von einer umlaufenden Nut 4 umgeben. Die Nut 4 stellt beispielsweise eine den ersten Bereich 2 durchgehend umlaufende Rille dar, wobei die Nut 4 einen hutförmigen, wie in Figur 2 dargestellt, einen halbkreisförmigen oder einen anders gearteten Querschnitt aufweisen kann. Beispielsweise weist die Nut 4 eine Breite und eine Tiefe von ca. 3 mm auf.

Elektrische Leiterbahnen 5 sind in dem zweiten Bereich 3 des Trägers 1 integriert und verlaufen vorzugsweise durch die Nut 4 hindurch in den ersten Bereich 2 hinein, wie in Figur 1 ersichtlich ist. Die Leiterbahnen 5 bestehen vorzugsweise aus Silber, Nickel, Zinn/Blei, Gold (galvanisch oder chemisch), etc., entsprechend der jeweiligen Funktion der entsprechenden Leiterbahn, und sind vorzugsweise mittels eines MID-Verfahrens gebildet.

Ein derartiges MID-Verfahren stellt beispielsweise das Heißpräge-Verfahren dar. Hierbei wird zunächst das Kunststoff-Substrat bzw. der Kunststoff-Träger gespritzt und anschließend das Substrat zusammen mit einer aufgelegten Folie in einer Presse gepreßt. Durch einen Prägevorgang bei einer vorbestimmten Temperatur werden die einzelnen Leiterbahnen aus der Folie in das Substrat geprägt. Abschließend wird die Restfolie von dem Substrat abgezogen und die Leiterbahnen 5 verbleiben auf dem Substrat. Wesentlich beim Heißprägen ist das Folienmaterial, beispielsweise aus elektrolytisch gewonnenem Kupfer, mit einer scherfreundlichen Kristallstruktur. Durchkontaktierungen sind möglich, indem man die Folie in vorgeformte Löcher im Substrat einprägt. Diese werden mit Leitpaste gefüllt. Das Heißprägeverfahren stellt ein sehr schnelles und sauberes Verfahren zur Metallisierung dar. Bei diesem MID-Verfahren können die Leiterbahnen 5 auf die oben beschriebene Weise auch in die Nut 4 eingeprägt werden. Allerdings sollte die Neigung der Nut 4 eher flach ausgebildet und mit abgerundeten Ecken versehen sein, da es sich bei der Kupfer-Folie um sehr dünne Leiterbahnen handelt.

Ein weiteres MID-Verfahren stellt die Laser-Effekt-Strukturierung dar. Hierbei wird der Kunststoff-Träger gespritzt und mit einer Kupfer-Schicht, beispielsweise durch ein chemisches und/oder elektrolytisches Verfahren, beschichtet. Die Oberfläche des Kunststoff-Trägers wird zum Beispiel mittels eines Lasers aktiviert, damit die anschließend aufgetragene Kupfer-Schicht an den aktivierten Bereichen abgeschieden werden kann. Nach Auftragen und Bilden einer Maske auf der Kupfer-Schicht wird das Kupfer entsprechend der verwendeten Maske an bestimmten Bereichen weggeätzt und die übrig gebliebenen Kupfer-Leiterbahnen mittels einer Oberflächen-Veredelung befestigt. Bei diesen MID-Verfahren ist ein steilerer Winkel der Nut 4 möglich, da die Leiterbahnen 5 stabiler ausgebildet sind.

Selbstverständlich sind weitere MID-Verfahren, wie beispielsweise das Maskenverfahren, der ZweiKomponenten-Spritzguß oder das Hinterspritzen einer Folie, ebenfalls anwendbar, um Leiterbahnen 5 auf dem Träger 1 von dem ersten Bereich 2 durch die Nut 4 hindurch in den zweiten Bereich 3 zu bilden.

Figur 2 zeigt eine Querschnittsansicht der erfindungsgemäßen Anordnung gemäß dem Ausführungsbeispiel der vorliegenden Erfindung. Wie in Figur 2 ersichtlich ist, verlaufen die Leiterbahnen 5 von im Kraftfahrzeug vorgesehenen Sensoren oder Aktuatoren (nicht dargestellt) beispielsweise von links von dem zweiten Bereich 3 durch die Nut 4 hindurch in den ersten Bereich 2 hinein. Wie in Figur 2 ferner ersichtlich ist, sind die Leiterbahnen 5 im ersten Bereich 2 beispielsweise über einen Bond-Draht 10 mit beispielsweise einer Hybrid-Schaltung 7 oder einem Steuergerät verbunden.

Ferner ist zur Abdeckung der Hybrid-Schaltung 7 ein Deckel 8 vorgesehen, welcher an der Unterseite eine der Form der Nut 4 entsprechende Feder 9 bzw. Gegenrastanformung 9 aufweist. Somit kann der Deckel 8 mittels der vorzugsweise umlaufend ausgebildeten Feder 9 in die Nut 4 auf eine KleberSchicht 6 eingesetzt werden. In der Nut 4 befindet sich dazu auf den Leiterbahnen 5 vorzugsweise ein geeigneter Klebstoff, beispielsweise ein DC 866-Klebstoff. Dabei gilt es zu beachten, daß ausreichend Klebstoff 6 in die Nut 4 gefüllt wird, jedoch sollte vermieden werden, daß bei einer zu großen Menge Klebstoff 6 beim Einsetzen des Deckels 8 in die Nut 4 ein Austreten des Klebstoffes 6 auf die Oberfläche des Trägers 1 auftritt und die jeweiligen angeordneten elektrischen Schaltungen bzw. Leiterbahnen beschädigt.

Nach einem Aushärten des Klebstoffes 6 ist auf diese Weise eine dichte Abdeckung des Innenbereiches 2 und somit der Hybrid-Schaltung 7 geschaffen, wobei die Materialien der jeweiligen Bauelemente, d.h. des Trägers 1, des Klebstoffes 6 und des Deckels 8 vorzugsweise derart auszubilden sind, daß sie gegen das abzudichtende Medium, beispielsweise Maschinenöl, resistent sind.

Beispielsweise besteht der Deckel aus einem Kunststoff (PBT, PA, ABS, PEI und PES etc.).

Wie oben bereits erläutert kann die Nut 4 verschiedene Querschnittsformen aufweisen. Welche Querschnittsform geeignet ist, hängt im wesentlichen von den verwendeten MID-Verfahren ab. Bei Verfahren, welche dünne Leiterbahnen 5 liefern, sollte die Nut 4 eher abgerundete Kanten und einen rundlichen Querschnitt aufweisen, um Knicke oder Brüche der Leiterbahnen 5 zu vermeiden. Hingegen können bei MID-Verfahren, welche dickere Leiterbahnen 5 liefern, auch kantige, stärker geneigte Querschnitte der Nut 4 vorgesehen werden. Typische Breiten und Tiefen der Nut 4 liegen bei ca. 3 mm.

Somit schafft die vorliegende Anordnung elektrische MID-Leiterbahnen, welche durch die Klebenut 4 zu dem anzusteuernden Steuergerät bzw. zu der anzusteuernden Komponente dicht geführt und gleichzeitig durch den Gehäusedeckel 8 und den Kunststoff-Träger 1 zusammen mit dem Innenbereich2 abgedichtet werden.

Obwohl die vorliegende Erfindung anhand eines bevorzugten Ausführungsbeispiels vorstehend beschrieben wurde, ist sie darauf nicht beschränkt, sondern auf vielfältige Weise modifizierbar.

### BEZUGSZEICHENLISTE:

| | |
|---|---|
| I | Träger |
| 2 | Erster Bereich |
| 3 | Zweiter Bereich |
| 4 | Nut |
| 5 | Leiterbahn |
| 6 | Klebstoff |
| 7 | Hybrid-Schaltung/Steuergerät |
| 8 | Abdeckeinrichtung/Deckel |
| 9 | Gegenrastanformung/Feder |
| 10 | Bond-Draht |

## Patentansprüche

1. Anordnung zum Führen von elektrischen Leiterbahnen (5) mit:
einem Träger (1), welcher auf seiner Oberfläche einen ersten abzudichtenden Bereich (2) und einen daran angrenzenden zweiten Bereich (3) zum Führen der auf dem Träger (1) angeordneten elektrischen Leiterbahnen (5) aufweist;
einer in der Oberfläche des Trägers (1) vorgesehenen Nut (4), welche den ersten Bereich (2) umläuft; und mit
einer Abdeckeinrichtung (8), welche in die umlaufende Nut (4) für eine dichte Abdeckung des ersten Bereichs (2) einsetzbar ist,
**dadurch gekennzeichnet, dass** die elektrischen Leiterbahnen (5) für eine elektrische Verbindung zwischen dem ersten Bereich (2) und dem zweiten Bereich (3) durch die Nut verlaufen.

2. Anordnung nach Anspruch 1,
**dadurch gekennzeichnet, daß**
die elektrischen Leiterbahnen (5) als MID-Leiterbahnen auf der Oberfläche des Trägers (1) gebildet sind.

3. Anordnung nach Anspruch 1 oder 2,
**dadurch gekennzeichnet, daß**
die Nut (4) einen hutförmigen, halbkreisförmigen oder rechteckigen Querschnitt aufweist.

4. Anordnung nach wenigstens einem der vorhergehenden Ansprüche,
**dadurch gekennzeichnet, daß**
die Abdeckeinrichtung (8) als Deckel (8) mit einer der Nut (4) zugeordneten Gegenrastanformung (9) ausgebildet ist.

5. Anordnung nach Anspruch 4,
**dadurch gekennzeichnet, daß**
die Gegenrastanformung (9) als umlaufende Feder (9) ausgebildet ist.

6. Anordnung nach wenigstens einem der vorhergehenden Ansprüche,
**dadurch gekennzeichnet, daß**
die Abdeckeinrichtung (8) mittels eines Klebstoffes (6) in der Nut (4) befestigbar ist.

7. Anordnung nach wenigstens einem der vorhergehenden Ansprüche,
**dadurch gekennzeichnet, daß**
auf dem ersten Bereich (2) ein Steuergerät bzw. eine Hybrid-Schaltung (7) angeordnet und mit den elektrischen Leiterbahnen (5) verbindbar ist.

8. Anordnung nach wenigstens einem der vorhergehenden Ansprüche,
**dadurch gekennzeichnet, daß**
die Materialien des Trägers (1), des Klebstoffes (6) und der Abdeckeinrichtung (8) resistent gegen Maschinenöl sind.

9. Anordnung nach wenigstens einem der vorhergehenden Ansprüche,
**dadurch gekennzeichnet, daß**
der Träger (1) aus Kunststoff, gebildet ist.

10. Anordnung nach Anspruch 9, **dadurch gekennzeichnet, dass** der Träger aus PBT, PA, ABS, PEI oder PPA-GF45 gebildet ist.

## Claims

1. Arrangement for carrying electrical conductors (5) comprising:
a carrier (1), which has on its surface a first region (2) to be sealed and a second region (3), adjoining the first, for carrying the electrical conductors (5) arranged on the carrier (1);
a groove (4), which is provided in the surface of the carrier (1) and runs around the periphery of the first region (2); and comprising
a covering device (8), which can be inserted into the peripheral groove (4) for a sealed covering of the first region (2),
**characterized in that** the electrical conductors (5) for an electrical connection between the first region (2) and the second region (3) run through the groove.

2. Arrangement according to Claim 1, **characterized in that** the electrical conductors (5) are formed as MID conductors on the surface of the carrier (1).

3. Arrangement according to Claim 1 or 2, **characterized in that** the groove (4) has a hat-shaped, semicircular or rectangular cross section.

4. Arrangement according to at least one of the preceding claims, **characterized in that** the covering device (8) is formed as a cover (8) with a mating latching formation (9) assigned to the groove (4).

5. Arrangement according to Claim 4, **characterized in that** the mating latching formation (9) is formed as a peripheral spring (9).

6. Arrangement according to at least one of the preceding claims, **characterized in that** the covering device (8) can be fastened in the groove (4) by means of an adhesive (6).

7. Arrangement according to at least one of the preceding claims, **characterized in that** a control device or a hybrid circuit (7) is arranged on the first region (2) and can be connected to the electrical conductors (5).

8. Arrangement according to at least one of the preceding claims, **characterized in that** the materials of the carrier (1), of the adhesive (6) and of the covering device (8) are resistant to engine oil.

9. Arrangement according to at least one of the preceding claims, **characterized in that** the carrier (1) is formed from plastic.

10. Arrangement according to Claim 9, **characterized in that** the carrier is formed from PBT, PA, ABS, PEI or PPA-GF45.

## Revendications

1. Dispositif de positionnement de pistes conductrices électriques (5) comprenant :
- un support (1) qui présente sur sa surface une première zone à rendre étanche (2) et une deuxième zone (3) adjacente à celle-ci pour positionner des pistes conductrices électriques (5) disposées sur le support (1) ;
- une rainure (4) dans la surface du support (1), qui entoure la première zone (2), et
- un dispositif de couverture (8) que l'on peut insérer dans la rainure périphérique (4) pour assurer une couverture étanche de la première zone (2),
**caractérisé en ce que**
les pistes conductrices électriques (5) traversent la rainure pour établir une liaison électrique entre la première zone (2) et la deuxième zone (3).

2. Dispositif selon la revendication 1,
**caractérisé en ce que**
les pistes conductrices électriques (5) sont des pistes conductrices MID formées à la surface du support (1).

3. Dispositif selon la revendication 1 ou 2,
**caractérisé en ce que**
la rainure (4) présente une section transversale en forme de chapeau, de demi-cercle ou rectangulaire.

4. Dispositif selon au moins l'une quelconque des revendications précédentes,
**caractérisé en ce que**
le dispositif de couverture (8) est un couvercle (8) muni d'une contre-forme d'accrochage (9) associée à la rainure (4).

5. Dispositif selon la revendication 4,
**caractérisé en ce que**
la contre-forme d'accrochage (9) est un ressort périphérique (9).

6. Dispositif selon au moins l'une quelconque des revendications précédentes,
**caractérisé en ce que**
le dispositif de couverture (8) peut être fixé dans la rainure (4) au moyen d'une colle (6).

7. Dispositif selon au moins l'une quelconque des revendications précédentes,
**caractérisé en ce que**
sur la première zone (2) un appareil de commande ou un circuit hybride (7) peut être disposé et relié aux pistes conductrices électriques (5).

8. Dispositif selon au moins l'une quelconque des revendications précédentes,
**caractérisé en ce que**
les matériaux du support (1), de la colle (6) et du dispositif de couverture (8) sont résistants à l'huile pour machines.

9. Dispositif selon au moins l'une quelconque des revendications précédentes,
**caractérisé en ce que**
le support (1) est en matière plastique.

10. Dispositif selon la revendication 9,
**caractérisé en ce que**
le support est en PBT, PA, ABS, PEI ou PPA-GF45.
